# EUROPEAN PATENT SPECIFICATION

(11) **EP 0 680 151 B1**
(45) Date of publication and mention of the grant of the patent: **14.06.2000**
(21) Application number: 94200854.1
(22) Date of filing: 29.03.1994
(51) Int. Cl.: H03M 3/02, H03M 1/60

(54) **Analog-to-digital conversion device for low frequency low amplitude differential signals**
Analog/Digital-Wandler für niederfrequente, differentielle Signale geringer Amplitude
Dispositif de conversion analogique-numérique pour signaux différentials à basses fréquences et basses amplitudes

(43) Date of publication of application: 02.11.1995
(73) Proprietor: ALCATEL, 75008 Paris (FR)
(72) Inventor: Haspeslagh, Johan Joseph Gustaaf, B-3001 Heverlee (BE); Louagie, Filip Marcel, B-2000 Antwerpen (BE); Haspeslagh, Didier René, B-8531 Harelbeke (BE)
(74) Representative: Narmon, Gisèle Marie Thérèse

(56) References cited:
- EP-A- 0 354 060
- EP-A- 0 554 701
- GB-A- 2 256 551
- US-A- 4 048 574
- US-A- 5 039 989
- IEEE JOURNAL OF SOLID-STATE CIRCUITS, vol.27, no.12, December 1992 pages 1689 - 1696 KERTH ET AL 'AN OVERSAMPLING CONVERTER FOR STRAIN GAUGE TRANSDUCERS'
- IEEE INTERNATIONAL SOLID-STATE CIRCUITS CONFERENCE, vol.34, February 1991, NEW YORK, US pages 66 - 67, XP000237803 RIBNER ET AL '16B THIRD-ORDER SIGMA DELTA MODULATOR WITH REDUCED SENSITIVITY TO NONIDEALITIES'

## Description

The present invention relates to an analog-to-digital conversion device having a differential input and a digital output and being adapted to convert a relatively low frequency differential input signal to a digital output signal, said device including the cascade coupling of a chopper circuit, a differential amplifier circuit, a dechopper circuit and an analog-to-digital converter circuit, said chopper and dechopper circuit operating at a same first clock frequency, said analog-to-digital converter circuit operating at a second clock frequency, said first clock frequency (CLK) being equal to or being a multiple of said second clock frequency.

In such an analog-to-digital conversion device, the chopper circuit chops the low frequency differential input signal at a frequency higher than the highest frequency of the input signal. The differential amplifier circuit then amplifies the thus obtained chopped signal, whilst the dechopper circuit, which operates at the same frequency as the chopper circuit, converts the frequency of the amplified chopped signal back to the lower frequency of the input signal. The amplified input signal is then applied to the analog-to-digital converter circuit which converts it to a digital signal or word.

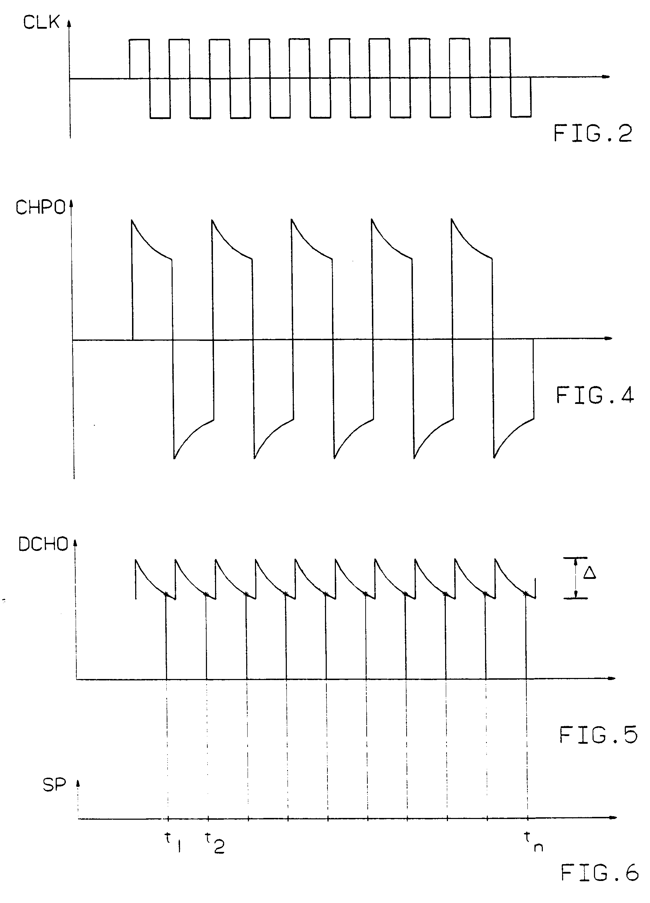

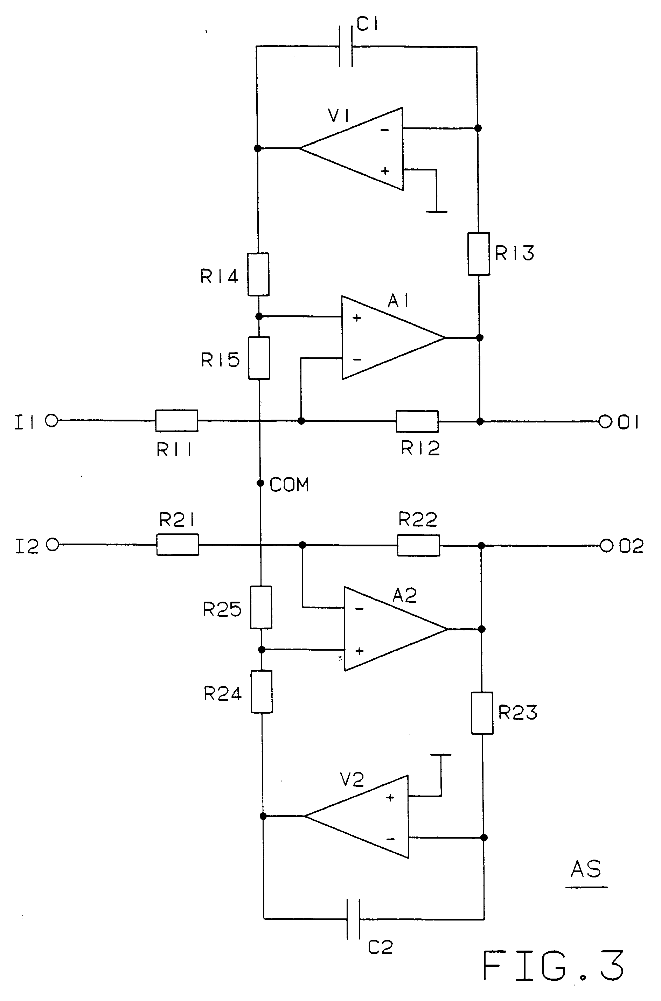

Such a device is already known in the art, e.g. from the UK patent application GB 2 256 551 " switched-capacitor integrator with chopper stabilization performed at the sampling rate" Therein, the combination of figs 4B and 7 discloses a chopper-stablised analog-to-digital conversion device having a differential amplifier with a chopper circuit at its input and a dechopper circuit at its output. As is further indicated in this document, embodiments exist whereby the sample frequency of the converter, corresponding to the second frequency, is equal to the chopping frequency or is equal to the chopping frequency divided by a positive integer.

It is also well known in the art that each amplifier circuit has a DC offset voltage which is amplified together with the useful signal applied at its input.

This DC offset voltage does not create a problem ina device where the amplitude of the input signal is so high that the unwanted DC offset voltage does not distort the useful signal.

However, in case a very low amplitude input signal needs to be converted, the required gain of the differential amplifier circuit should be much higher, e.g. in the order of 300. The differential amplifier circuit will then generally include several amplifier stages and the offset signal generated in each amplifier stage will be amplified by the gain of that stage. Because of the high overall gain of the differential amplifier circuit, the unwanted offset signal may reach an unacceptable amplitude and may saturate the amplifier circuit, thereby distorting the useful amplified signal.

Moreover, while the dechopper circuit converts the frequency of the amplified chopped signal to the low frequency of the input signal, it also converts the frequency of the offset signal to the chopper frequency. This offset signal with a relatively high amplitude and at the chopper frequency may then also saturate the analog-to-digital converter circuit to which it is applied.

This problems were not mentioned in the above prior art document

In US patent 4048574 column 5, lines 22-33, the offset problem is solved by means of a high pass filter placed after the amplifier.

High-pass filters in-between the amplifier stages, or after one amplifier in case of only one stage, have the goal to prevent unwanted low frequency signals, such as the DC offset voltage or the 1/f noise, from being transmitted from one amplifier stage to another, but to allow such transmission for the useful signal converted to the higher chopper frequency.

However, such high-pass filters are space consuming on the chip. For the same reason of space consumption, no conventional coupling capacitor, as the one shown in the mentioned US patent application 4048574, can be used. Moreover they are subjected to temperature drifts and to technology variations, and additionally, they negatively affect the step response of the amplifier stages.

Indeed, since the signal at the output of the dechopper circuit is a mapped, i.e. converted, amplified output signal having a rectangular wave shape and that this mapped signal has to be transformed to a digital output signal or word by the analog-to-digital converter circuit, it is important that the corners of the pulses of the chopped signal have a low cut-off. Any deformation of the rectangular shape of these pulses, e.g. due to high-pass filtering, appears also in the remapped signal, i.e. in the signal supplied to the input of the analog-to-digital converter circuit. As a consequence, a conversion error is introduced in the digital output signal.

This problem, relates to a second problem with an analog-to-digital conversion device , consisting of the fact that the presence of chopper and dechopper circuits leads to unwanted frequency components appearing at the digital output. These unwanted frequency components need to be eliminated.

In the known case of a negligible offset signal, the unwanted frequencies may for instance be eliminated by a digital low-pass filter located at the output of the analog-to-digital converter circuit.

In case of a smaller input signal, i.e. of an input signal with a lower amplitude, and thus of an amplifier circuit with a higher gain, a known solution to eliminate the unwanted frequencies is to provide a so-called anti-aliasing filter between the dechopper circuit and the analog-to-digital converter circuit. Such an anti-aliasing filter is a low-pass filter which removes the high amplitude unwanted signals having a frequency above a predetermined frequency value, generally equal to half the operating frequency of the analog-to-digital converter circuit. This solution is for instance described in the document "*High performance analog interfaces for digital signal processors*" by F. Op't Eynde, November 1990, published by the K.U.L. (Katholieke Universiteit Leuven/Belgium), and more particularly on pages 102 to 105 of chapter 3 thereof: "Oversampled A-to-D and D-to-A converters", this document being hereafter referred to as document [1].

However, although an anti-aliasing filter prevents the analog-to-digital converter circuit from being saturated by the high amplitude unwanted signals, it introduces an additional offset voltage which again needs to be eliminated and it is not easy to reproduce with accuracy when integrated in an electronic chip. The use of an anti-aliasing filter is therefore preferably avoided.

Nevertheless, because of the relation between the first and the second clock frequency, which was already present in the first mentioned prior art document, UK patent application 2 256 551, the error on the corners of the pulses of the remapped, i.e. converted, and amplified signal has no longer a negative influence on the output digital signal of the analog-to-digital converter circuit. Indeed, since this error is substantially equal for each pulse and since the converter circuit operates at the chopper/dechopper frequency or at a sub-multiple thereof it always takes a sample at a same position within these pulses. The error introduced in the converted signal by the chopping and dechopping operation is thus automatically minimized without requiring the use of any filter. The problem of unwanted frequency components is thereby eliminated.

An object of the present invention is to provide an analog-to-digital conversion device of the above known type but which is adapted to convert input signals having a relatively low amplitude and wherein unwanted signals, such as the DC offset signal, are suppressed without using neither space consuming high-pass filters in-between the amplifier stages.

According to the invention, this object is achieved due to the fact that said differential amplifier circuit includes at least one amplifier stage which is a differential high-pass amplifier circuit.

By acting as a high-pass filter, each amplifier stage individually suppresses unwanted low frequency signals, while amplifying the useful signal which passes through it.

Other characteristic features of the present invention are that said high-pass amplifier circuit includes a pair of amplifier sections each having an associated distinct negative feedback circuit including a low-pass filter, that said negative feedback circuit further includes a voltage divider, and that said low-pass filter is an integrator circuit of which an output is connected to an input of said associated amplifying section via said voltage divider.

In this way, the voltage divider scales the pole of the integrator circuit and thus the function of the high-pass filter of the amplifier stage.

Still another characteristic feature of the present invention is that said voltage divider comprises the series connection of two resistors of which the junction point is connected to an input of said amplifying section, and that the two voltage dividers of said amplifier stage are interconnected at a common floating terminal.

Owing to this common floating terminal a possible unwanted common mode signal appearing in the device is eliminated. Indeed, the feedback circuit works then as if the output of the integrator circuit is not attenuated by the voltage divider, i.e. as if there is no voltage divider.

The above mentioned and other objects and features of the invention will become more apparent and the invention itself will be best understood by referring to the following description of an embodiment taken in conjunction with the accompanying drawings wherein :
Fig. 1 represents an analog-to-digital conversion device ADD according to the invention;
Fig. 2 shows a clock signal CLK used in the analog-to-digital conversion device ADD of Fig. 1;
Fig. 3 is a schematic view of an amplifier stage AS included in the differential amplifier AMP of the device ADD of Fig. 1; and
Figs. 4 to 6 show signals appearing in the analog-to-digital conversion device ADD of Fig. 1.

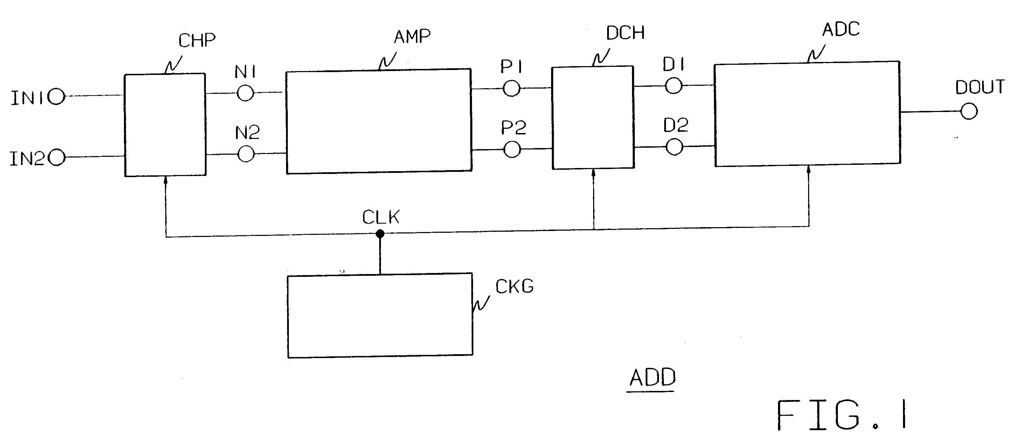

The analog-to-digital conversion device ADD shown in Fig. 1 may be used in applications where a very low amplitude and low frequency differential analog input signal needs to be converted to a digital output signal or word. The device ADD therefore obviously includes an analog-to-digital converter ADC coupled between a differential input with terminals IN1/IN2 and a single-ended digital output terminal DOUT.

Generally, the analog input signal which is applied to the input of such a converter ADC must have an amplitude which varies at most between +1 and -1 Volt in order to allow its conversion to a digital signal or word, e.g. of 15 bits. For this reason, the small analog input signal needs to be strongly amplified prior to being applied to ADC. Therefore, this differential input signal, which may have a frequency varying from DC (included) up to about 100 Hz and which is hereafter called "DC signal", is first chopped, i.e. modulated with a square wave, by a chopper circuit CHP. The obtained chopped signal is then amplified by a differential amplifier AMP and its frequency is finally brought back to its initial value by a dechopper circuit DCH before being applied to the converter ADC.

Additionally to the cascade coupling of CHP, AMP, DCH and ADC, ADD further includes a clock generator CKG.

The clock generator CKG generates a 64 kHz clock signal CLK which is applied to CHP, DCH and ADC in order to control them.

It is to be noted that in the following part of the description and in the drawings, a same clock signal CLK, as shown in Fig. 2, is applied to CHP, DCH and ADC. However, as it will become clear later, it is sufficient that the frequency of the clock signal applied to CHP and DCH is a multiple of the frequency of the clock signal applied to ADC.

The chopper circuit CHP has the differential input with terminals IN1/IN2 of the device ADD and under control of the clock signal CLK generates a chopped signal at a differential output with terminals N1/N2. The chopped signal is substantially a block wave modulated by the DC input signal and has a frequency of 32 kHz.

The chopper circuit CHP has a classical structure and is therefore not described in detail here. Information about chopper circuits may for instance be found in the book "*Pulse, Digital and Switching Waveforms*" by J. Millman and H. Taub, published by the McGRAW-HILL BOOK COMPANY (International Student Edition, 1965) and more particularly in sections 17-13 to 17-18 thereof at pages 647 to 658.

The output N1/N2 of CHP is connected to like-named differential input of the differential amplifier AMP. This amplifier AMP may be constituted by a single AC amplifier stage but since its gain needs to be very high, several amplifier stages mounted in cascade are preferred. Between its differential input N1/N2 and its differential output P1/P2, AMP therefore includes several differential amplifier stages similar to AS, shown in Fig. 3.

The differential amplifier stage AS has a differential input terminal I1/I2 coupled to the input N1/N2 of AMP and a differential output O1/O2 coupled to the output N1/N2 of AMP. The differential amplifier stage AS is symmetrical and includes two complementary parts each comprising an amplifying section and a low-pass filter feedback circuit. The first part comprises operational amplifiers A1 and V1, resistors R11 to R15 and capacitor C1, whilst the second part comprises operational amplifiers A2 and V2, resistors R21 to R25 and capacitor C2. Since AS is a symmetrical differential amplifier, the two parts thereof are identical and only one of them, say the first one, will be described hereafter.

The amplifying section comprises the operational amplifier A1, resistor R11 connected as input resistor of A1 between the input I1 and the inverting input (-) of A1, and negative feedback resistor R12 connected between the output of A1 and its inverting input, the output of A1 being further also connected to the output O1 of AS.

The low-pass filter feedback circuit comprises the operational amplifier V1 whose non-inverting input (+) is grounded, a resistor R13 connected between the output of A1 and the inverting input (-) of V1, a capacitor C1 connected in parallel to V1 between its output and its inverting input, and a voltage divider constituted by the series connection of resistors R14 and R15 branched between the output of V1 and a terminal COM which is floating but common for the two parts of AS. The junction point of R14 and R15 is connected to the non-inverting input (+) of A1.

This low-pass filter feedback circuit is an integrator circuit whereby the amplifier stage AS behaves as an high-pass filter.

In the present case where the DC input signal is very small with respect to the unwanted DC offset voltage inherent to each amplifier, high-pass filtering is very important because it will eliminate this unwanted signal as will be explained below.

In the amplifier stage AS the DC offset voltage, which lies in the same low frequency range as the DC input signal, is amplified together with the useful signal, i.e. with the chopped DC signal, but because it is larger it may have a negative effect thereon. If this amplified unwanted signal should be transmitted from one stage to another of the differential amplifier AMP, it could lead to a saturation of the latter and introduce unacceptable errors on the output signal or word.

This drawback is avoided by the high-pass filter which only needs to have a pole located at a frequency between DC and the chopping frequency, i.e. 32 kHz. All the unwanted signals having a frequency located below this pole are so eliminated, whilst the useful signal mapped at 32 kHz by the chopper circuit CHP is not attenuated by the filter. Only this useful signal is thus amplified and transmitted from one stage to the other of the differential amplifier AMP.

Moreover, the use of a voltage divider in the integrator circuit fakes a much larger capacitor than C1. As a result the space occupied by the integrator circuit on the electronic chip in which it is integrated is reduced.

The unity gain frequency of the integrator circuit, and thus the pole of the high-pass filter, is scaled by the voltage divider R14-R15 coupling the integrator circuit to the amplifying section. This voltage divider strongly limits the dynamic range of the fed back low frequency signal. In fact, the maximum amplitude of the feedback is the maximum output voltage of the integrator circuit divided by the factor of the voltage division.

If the differential amplifier AMP has several stages, high-pass filtering is especially useful in the first stage or stages thereof because therein the chopper signal is still relatively low. For this reason it is preferred to use the amplifier stage AS at least in the first stage(s) of the differential amplifier AMP.

In the fully differential implementation of the amplifier stage AS, attention is also paid to its common mode behaviour. A common mode signal may not limit the dynamic range of the useful chopped signal. To this end and as already mentioned, the common terminal COM of the voltage dividers R14-R15 and R24-R25 is floating. Hence, for a common mode signal there flows no current in the voltage dividers and the voltage at the common terminal COM follows the common mode signal at the inputs. This means that for a common mode signal the feedback circuit works as if the output of the integrator circuit was not attenuated by the voltage divider, i.e. as if there was no voltage divider. Common mode and differential mode signals are thus filtered at the same time, but with a different characteristic, i.e. with different pole and attenuation, so that large low frequency components of a common mode signal are attenuated, whilst small low frequency components of the differential mode signal are still filtered out.

In other words, common mode signal low frequency components decrease only slightly the dynamic range of differential signal low frequency components that are filtered out, and the common mode signal is filtered stronger than the useful differential signal by the high-pass filter but with a higher pole determined by the voltage divider which no longer influences the characteristics of the integrator circuit.

The outputs P1/P2 of the differential amplifier AMP are connected to like-named differential inputs of the dechopper circuit DCH. Similarly to the chopper circuit CHP, the dechopper circuit DCH operates under the control of the clock signal CLK and has a classical structure well known in the art. DCH is therefore not described in detail hereafter. DCH has differential outputs D1/D2 at which a dechopped signal, i.e. a signal converted to the DC level, appears. The outputs D1/D2 of DCH are connected to like-named differential inputs of the analog-to-digital converter ADC.

As we deal here with an output signal of AMP which is synchronously converted to a digital signal or word by the converter ADC, it is of importance that the step response of the amplifier stage(s) AS of AMP is very good. This means that the corners of the rectangular pulses of the chopped signal must have a low cut-off. Unfortunately, the high-pass filtering of the AS stages provide spikes which appear at each level transition of the 32 kHz chopped signal. Such an adversely affected chopped signal CHPO is shown in Fig. 4. It is to be noted, however, that in this Fig. 4 the size of the spikes is strongly exaggerated only to shown the phenomenon.

As a result of these spikes, the remapped DC signal DCHO appearing at the output D1/D2 of the dechopper circuit DCH has a ripple of 64 kHz, as shown in Fig. 5.

In the known prior art, e.g. in the above discussed document [1], such possible spikes and harmonics of the signal at the output D1/D2 of DCH are eliminated by a low-pass filter anti-aliasing filter located between the dechopper circuit DCH and the converter ADC. The goal of the anti-aliasing filter is to eliminate, at the input D1/D2 of the converter ADC any signal at a frequency higher than half the sampling frequency, i.e. half the clock frequency CLK at which ADC operates.

Such an anti-aliasing filter which also introduces a DC offset voltage and which is not easy to reproduce with accuracy when integrated in a chip because of technological variations is no longer required in the present case owing to the fact that, as will be described later, the converter ADC operates at the same clock frequency CLK as the chopper CHP and dechopper DCH circuits or at least at a sub-multiple thereof.

As already mentioned, the analog-to-digital converter ADC has the differential input D1/D2 and the digital output terminal DOUT of ADD. A converter as ADC is also well known in the art and may for instance be a Sigma-Delta modulator, e.g. as described in the above document [1]. Therefore, the architecture of ADC will not be described in detail here.

The converter ADC samples the input signal, say DCHO, at the rate of the clock CLK, i.e. at moments t1, t2, ..., tn shown in Fig. 6. As both the ripple frequency of DCHO and the sampling frequency are equal and synchronized at 64 kHz, the samples are always taken at a same position within the pulses of DCHO. This is obviously also true when the clock frequency at which ADC operates is a sub-multiple of the clock frequency at which CHP and DCH operate.

Since the error on the digital output signal is proportional to the amplitude of the ripple on the signal DCHO, as represented by △ in Fig. 5, it clearly appears that taking the samples always at a same position within the pulses drastically reduces the effect of this error. This position is preferably the middle of the pulse because the error is then minimum.

As a result, by keeping this strong relation between the sampling frequency and the shopping and dechopping frequency, the error on the output signal is minimized without low-pass filter being necessary between the dechopper circuit DCH and the converter ADC.

It is finally to be noted that the amplitude of the ripple △ is also minimized when the pole of the high-pass filter of the amplifier stage AS is located near to the DC frequency.

While the principles of the invention have been described above in connection with specific apparatus, it is to be clearly understood that this description is made only by way of example and not as a limitation on the scope of the invention.

## Claims

1. Analog-to-digital conversion device (ADD) having a differential input (IN1/IN2) and a digital output (DOUT) and being adapted to convert a relatively low frequency differential input signal to a digital output signal or word, said device including the cascade coupling of a chopper circuit (CHP), a differential amplifier circuit (AMP), a dechopper circuit (DCH) and an analog-to-digital converter circuit (ADC), said chopper and dechopper circuit operating at a same first clock frequency, said analog-to-digital converter circuit operating at a second clock frequency, said first clock frequency (CLK) being equal to or being a multiple of said second clock frequency, **characterized in that** said differential amplifier circuit (AMP) includes at least one amplifier stage (AS) which is a differential high-pass amplifier circuit comprising a pair of amplifier sections (A1, R11, R12; A2, R21, R22) each having an associated distinct negative feedback circuit (V1, C1, R13-R15; V2, C2, R23-R25) including a low-pass filter (V1, C1, R13; V2, C2, R23).

2. Analog-to-digital conversion device according to claim 1, characterized in that said negative feedback circuit (V1, C1, R13-R15; V2, C2, R23-25) further includes a voltage divider (R14-R15; R24-R25), and in that said low-pass filter (V1, C1, R13; V2, C2, R23) is an integrator circuit of which an output is connected to an input of said associated amplifying section (A1, R11, R12; A2, R21, R22) via said voltage divider.

3. Analog-to-digital conversion device according to claim 2, characterized in that said voltage divider (R14-R15; R24-R25) comprises the series connection of two resistors of which the junction point is connected to an input of said amplifying section (A1, R11, R12; A2, R21, R22), and in that the two voltage dividers of said amplifier stage (AS) are interconnected at a common floating terminal (COM).

4. Analog-to-digital conversion device according to claim 1, characterized in that said differential amplifier circuit (AMP) is constituted by the series connection of a plurality of said amplifier stages (AS)

5. Analog-to-digital conversion device according to claim 1, characterized in that said dechopper circuit (DCH) is directly connected to said analog-to-digital converter circuit (ADC).

## Patentansprüche

1. Analog-Digital-Wandlervorrichtung (ADD), welche einen differentiellen Eingang (IN1/IN2) und einen digitalen Ausgang (DOUT) besitzt und geeignet ist, ein relativ niederfrequentes differentielles Eingangssignal in ein digitales Ausgangssignal oder Wort umzuwandeln, wobei die Vorrichtung eine Reihenschaltung aus einer Zerhackerschaltung (CHP), einer Differenzverstärkerschaltung (AMP), einer Enthackerschaltung (DCH) und einer Analog-Digital-Wandlerschaltung (ADC) beinhaltet, die Zerhacker- und Enthackerschaltung mit der gleichen ersten Taktfrequenz arbeiten, die Analog-Digital-Wandlerschaltung mit einer Zweiten Taktfrequenz arbeitet, und die erste Taktfrequenz (CLK) so groß ist wie die zweite Taktfrequenz oder ein Vielfaches von dieser, dadurch gekennzeichnet, daß die Differenzverstärkerschaltung (AMP) mindestens eine Verstärkerstufe (AS) beinhaltet, bei der es sich um eine Hochpaß-Differenzverstärkerschaltung handelt, welche ein Paar von Verstärkerabschnitten (A1, R11, R12; A2, R21, R22) aufweist, von denen jeder einen zugehörigen separaten Negativ-Rückführkreis (V1, C1, R13-R15; V2, C2, R23-R25) besitzt, der ein Tiefpaßfilter (V1, C1, R13; V2, C2, R23) beinhaltet.

2. Analog-Digital-Wandlervorrichtung nach Anspruch 1, dadurch gekennzeichnet, daß der Negativ-Rückführkreis (V1, C1, R13-R15; V2, C2, R23-R25) weiter einen Spannungsteiler (R14-R15; R24-R25) beinhaltet und das Tiefpaßfilter (V1, C1, R13; V2, C2, R23) eine Integratorschaltung ist, bei der ein Ausgang mit einem Eingang des zugehörigen Verstärkerabschnitts (A1, R11, R12; A2, R21, R22) über den Spannungsteiler verbunden ist.

3. Analog-Digital-Wandlervorrichtung nach Anspruch 2, dadurch gekennzeichnet, daß der Spannungsteiler (R14-R15; R24-R25) die Reihenschaltung von zwei Widerständen aufweist, deren Verbindungspunkt mit einem Eingang des Verstärkerabschnitts (A1, R11, R12; A2, R21, R22) verbunden ist, und daß die zwei Spannungsteiler der Verstärkerstufe (AS) bei einem gemeinsamen erdfreien Anschluß (COM) miteinander verbunden sind.

4. Analog-Digital-Wandlervorrichtung nach Anspruch 1, dadurch gekennzeichnet, daß die Differenzverstärkerschaltung (AMP) durch eine Reihenschaltung einer Mehrzahl von Verstärkerstufen (AS) gebildet ist.

5. Analog-Digital-Wandlervorrichtung nach Anspruch 1, dadurch gekennzeichnet, daß die Enthackerschaltung (DCH) direkt mit der Analog-Digital-Wandlerschaltung (ADC) verbunden ist.

## Revendications

1. Dispositif de conversion analogique-numérique (DAN) ayant une entrée différentielle (IN1/IN2) et une sortie numérique (TSN) et étant adapté pour la conversion d'un signal d'entrée différentiel à fréquence relativement faible en une formulation ou un signal de sortie numérique, ledit dispositif comprenant le couplage en cascade d'un circuit modulateur (CM), d'un circuit amplificateur différentiel AMP, d'un circuit démodulateur (CD) et d'un circuit convertisseur analogique-numérique (CAN), ledit circuit modulateur et démodulateur fonctionnant à une même première fréquence d'horloge, ledit circuit convertisseur analogique-numérique fonctionnant à une seconde fréquence d'horloge, ladite première fréquence d'horloge (HOR) étant égale à ou étant un multiple de ladite seconde fréquence d'horloge, caractérisé en ce que le circuit amplificateur différentiel AMP comprend au moins un étage amplificateur (EA) qui est une circuit amplificateur passe-haut différentiel comprenant deux sections d'amplification (A1, R11, R12 ; A2, R21, R22), chacune ayant un circuit de rétroaction négatif distinct associé (V1, C1, R13-R15 ; V2, C2, R23-R25) comprenant un filtre passe-bas (V1, C1, R13 ; V2, C2, R23).

2. Dispositif de conversion analogique-numérique selon la revendication 1, caractérisé en ce que ledit circuit de rétroaction négatif (V1, C1, R13-R15 ; V2, C2, R23-R25) comprend en outre un réducteur de tension (R14-R15 ; R24-R25), et en ce que ledit filtre passe-bas (V1, C1, R13 ; V2, C2, R23) est un circuit intégrateur dont une sortie est connectée à une entrée de ladite section d'amplification associée (A1, R11, R12 ; A2, R21, R22) par ledit réducteur de tension.

3. Dispositif de conversion analogique-numérique selon la revendication 2, caractérisé en ce que ledit réducteur de tension (R14-R15 ; R24-R25) comprend la connexion en série de deux résistances dont le point de jonction est connecté à une entrée de ladite section d'amplification (A1, R11, R12 ; A2, R21, R22), et en ce que les deux réducteurs de tension dudit étage amplificateur (EA) sont interconnectés à un terminal flottant commun (COM).

4. Dispositif de conversion analogique-numérique selon la revendication 1, caractérisé en ce que ledit circuit amplificateur (AMP) est constitué par la connexion en série de plusieurs desdits étages amplificateurs (EA).

5. Dispositif de conversion analogique-numérique selon la revendication 1, caractérisé en ce que ledit circuit démodulateur (CD) est connecté directement audit circuit convertisseur analogique-numérique.
